# EUROPEAN PATENT APPLICATION

(11) **EP 1 369 721 A2**
(43) Date of publication of application: **10.12.2003**
(21) Application number: 02256673.1
(22) Date of filing: 25.09.2002
(51) Int. Cl.: G02B 6/42, G02B 6/26, H04B 10/04, H04B 10/06, H04B 10/24, G02F 1/01

(54) **Optoelectronic module with integrated variable optical attenuator**

(30) Priority: 25.05.2002 GB 0212107
(71) Applicant: Agilent Technologies, Inc. - a Delaware corporation -, Palo Alto, CA 94303-0870 (US)
(72) Inventor: Chown, David Philip Martin, Ipswich, Suffolk IP7 6DE (GB)
(74) Representative: Coker, David Graeme

(57) **Abstract**

The present invention relates to an optoelectronic modules in which a variable optical attenuator (VOA) is incorporated with further passive and active optical components to form an integrated module which is inexpensive and yields small yet robust packages. The module provides for a variable output power and can be installed and replaced via a 'hot pluggable' connector.

Light (21) from semiconductor laser (24) is collimated by first lens (25) and transmitted through optional isolator (23) and (VOA 22) before being focused by second lens (26) into connector (28). Connector (28) is typically a fibre stub. At least one of either the laser, isolator and/or VOA may be mounted on a thermoelectric cooler in a hermetic enclosure. The light source, variable optical attenuator, and connector are mounted within the module housing (34). The isolator may also be mounted in the housing. The laser drive electronics and VOA controller are mounted on a (PCB 30), which may also be located within the module housing (34).

## Description

The present invention relates generally to optoelectronic modules and in particular, it relates to optoelectronic transmitter and transceiver modules. Furthermore, the present invention relates to an optoelectronic transceiver module which is inexpensive and yields small yet robust packages which provide for a variable output power and can be installed and replaced via a 'hot pluggable' connector.

Optoelectronic transmitter modules provide for the transmission of data between an electrical interface and an optical transmission system. The module receives electrically encoded data signals which are converted into optical signals and transmitted over the optical transmission system. In optical transmission systems known as wavelength division multiplexing (WDM) systems, or dense wavelength division multiplexing (DWDM) systems, different signals are carried on different wavelengths at data rates of 2.5Gbit/s, 10Gbit/s or 40Gbit/s.

DWDM systems are rapidly being adopted and the use of optical amplifiers, such as Erbium doped fibre amplifiers (EDFAs), in next generation DWDM systems will increase. In amplified DWDM systems non-uniform outputs of laser modules and wavelength dependent amplification of line amplifiers causes the signal power levels transmitted in a fibre to depend on wavelength. The inter-wavelength discrepancies in optical power levels can render normal system operation impossible, so the signal level for each wavelength must be adjusted. Variable optical attenuators (VOAs) are used to optimise the optical power of signals at key points in optical communications networks, for example, between stages of EDFAs, to provide constant gain and to set signal strength within the range of a particular receiver. Particularly they are used to adjust the optical power of multiple lasers when combined together before launching into a WDM system and to adjust optical power of "added" laser signals to match the signal strength of other channels within the network.

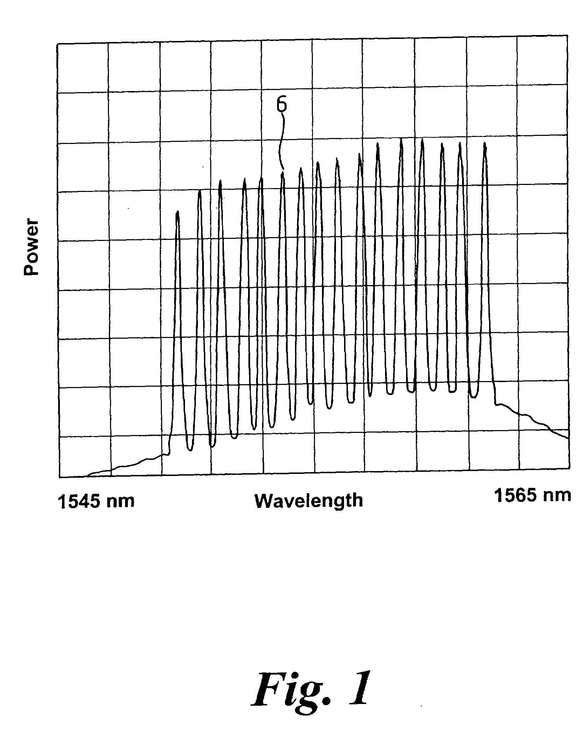

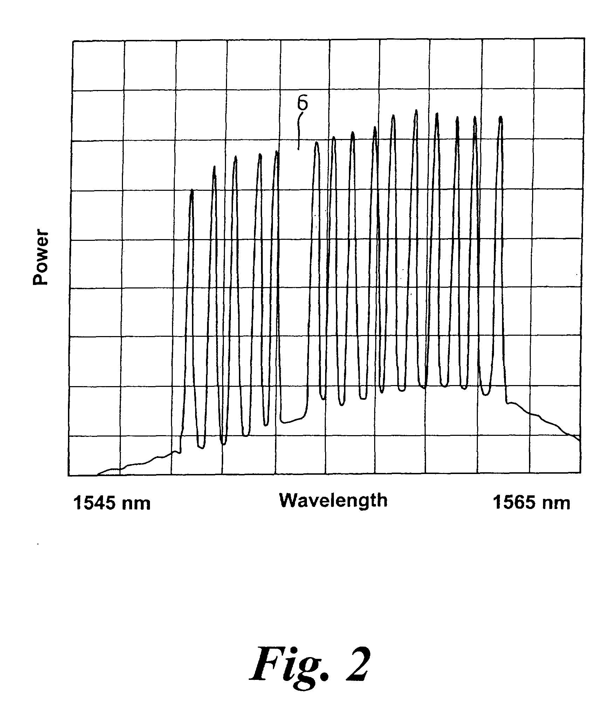

Figure 1 shows a graph of the output power spectrum of an EDFA with 16 WDM channels spaced at 0.8nm. Figure 2 shows the same power spectrum but with channel 6 missing resulting in an increase in power in the remaining 15 channels. The total output power of the amplifier remains almost constant - if one channel is dropped (or is added) then the remaining ones increase (or decrease) their output power.

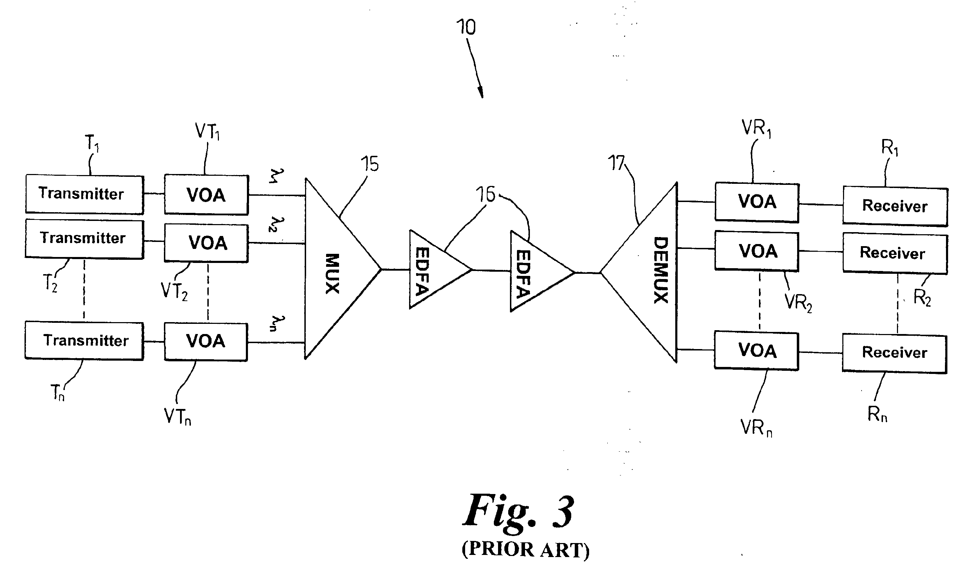

Figure 3 shows a portion of a typical optical communications network 10 where each transmitter (T₁, T₂, Tₙ) is connected to a VOA (VT₁, VT₂, VTₙ) and each VOA is connected to the multiplexer 15. The multiplexer is then connected one or more, depending on the length of the transmission system, EDFAs 16 which are connected to demultiplexer 17, then to a further set of VOAs (VR₁, VR₂, VRₙ) and receivers (R₁, R₂, Rₙ). These connections are typically made by splicing fibres together or by patchcords.

Splicing has the advantage of a low loss and stable connection, but is a difficult process and requires that the transmitter and VOA are mounted on the same circuit pack, thus reducing the number of transmitters which can be mounted on the circuit pack, and hence in the system rack.

Patchcords are simpler to use but connectors have generally higher and more variable losses than splices. Generally there would be a connection between the transmitter pigtail at the front panel of the transmitter circuit pack and a connection between the patchcord and the VOA pigtail at the front panel of the VOA circuit pack. The VOA circuit packs may be positioned on a shelf below the transmitter circuit packs in the system rack, hence reducing the number of shelves available for transmitters and thus the number of transmitters that can be mounted in the system.

There is a further disadvantage. With conventional pigtails and patchcords the state of polarisation at the input to the VOA is unknown and so the VOA has to be of the polarisation independent type, which is typically larger, more complex and more expensive than a polarisation dependent type. Alternatively polarisation maintaining (PM) pigtails and patchcords could be used. PM fibre is more expensive than standard fibre and assembling transmitters and patchcords with PM fibre is more difficult than with standard fibre.

Thus it is an object of the present invention to provide a transmitter or transceiver module with an internal VOA that can be controlled remotely and overcomes the above mentioned technical problems associated with know transmitter or transceiver arrangements, which use external VOAs.

According to the present invention that object is achieved by means of an optoelectronic module comprising a light source, a variable optical attenuator, and an output means, wherein said light source and said output means are optically connected via said variable optical attenuator; characterized in that said light source, said variable optical attenuator and said output means are disposed within a housing.

The output means is a preferably a fibre stub. The light source is preferably a laser. The module may further comprise an isolator disposed within the housing.

According to a further aspect of the present invention, the module comprises means for monitoring light transmitted by the variable optical attenuator. The means for monitoring light preferably comprises a beam splitter and a detector.

The variable optical attenuator may be a micro-electromechanical variable optical attenuator. Alternatively, the variable optical attenuator may be a liquid crystal variable optical attenuator.

The module may be a "hot pluggable" module.

The module may be an optical transceiver for use in a dense wavelength division multiplexing system.

Advantageously, the present invention provides a transmitter comprising a VOA which is itself compact and can be connected directly to the multiplexer eliminating the need for an external VOA and the requirement to connect to it using difficult splicing methods or lossy patchcords. Furthermore, the present invention allows for more transmitters to be mounted in the system rack, thus increasing the overall capacity of the system.

Because the VOA is fixed with respect to the rest of the transmitter, a polarisation dependent VOA can be used with consequent additional savings in space, complexity and cost.

While the principle advantages and features of the invention have been described above, a greater understanding and appreciation of the invention may be obtained by referring to the drawings and detailed description of a preferred embodiment, presented by way of example only, in which;
FIGURE 4a show a diagram of an optoelectronic model according to the present invention,
FIGURE 4b show a diagram of a model according to a further embodiment of the present invention,
FIGURE 5 shows a diagram of a first VOA for use in the modules shown in figures 4a or 4b, and
FIGURE 6 shows a diagram of a further VOA for use in the modules shown in figures 4a or 4b.

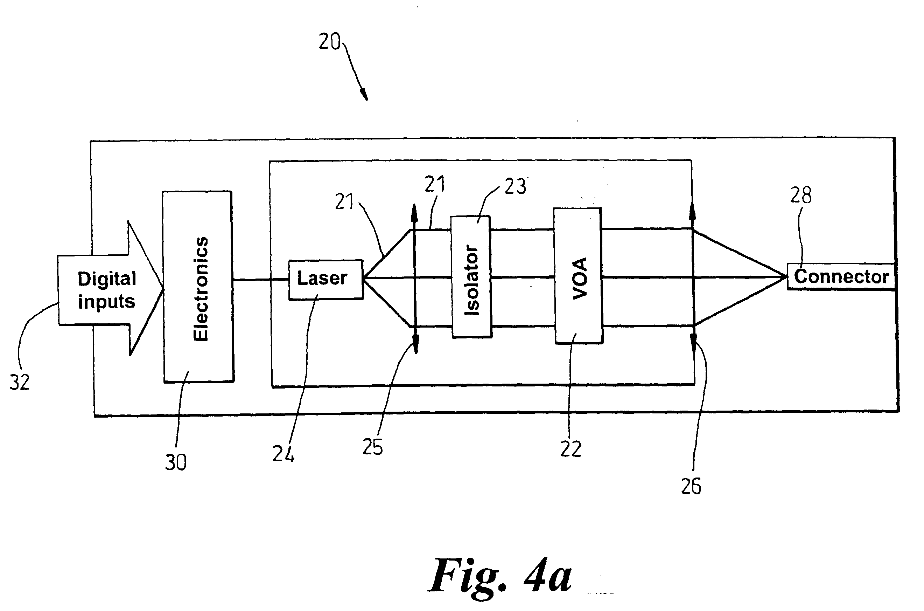

In figure 4a transmitter 20 comprises a single VOA 22. Light 21 from semiconductor laser 24 is collimated by first lens 25 and transmitted through optional isolator 23 and VOA 22 before being focused by second lens 26 into connector 28. Connector 28 is typically a fibre stub. At least one of either the laser, isolator and/or VOA may be mounted on a thermoelectric cooler (not shown) in a hermetic enclosure. The light source, variable optical attenuator, and connector are mounted within the module housing 34. The isolator may also be mounted in the housing. The laser drive electronics and VOA controller are mounted on a PCB 30, which may also be located within the module housing 34.

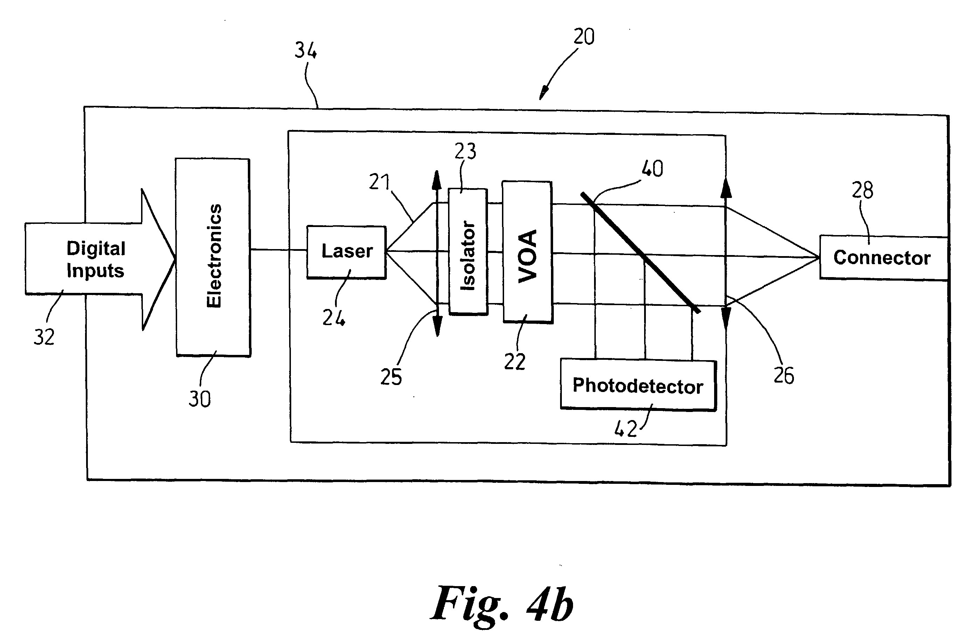

Figure 4b, where parts also appearing in figure 4a bear identical reference numbers, includes a means for monitoring the light transmitted by the VOA. The monitoring means is located within module housing 34 and comprises a beam splitter 40 disposed between the VOA 22 and the connector 28, and a detector 42. The operation of both the beam splitter and the detector are both well know in the art.

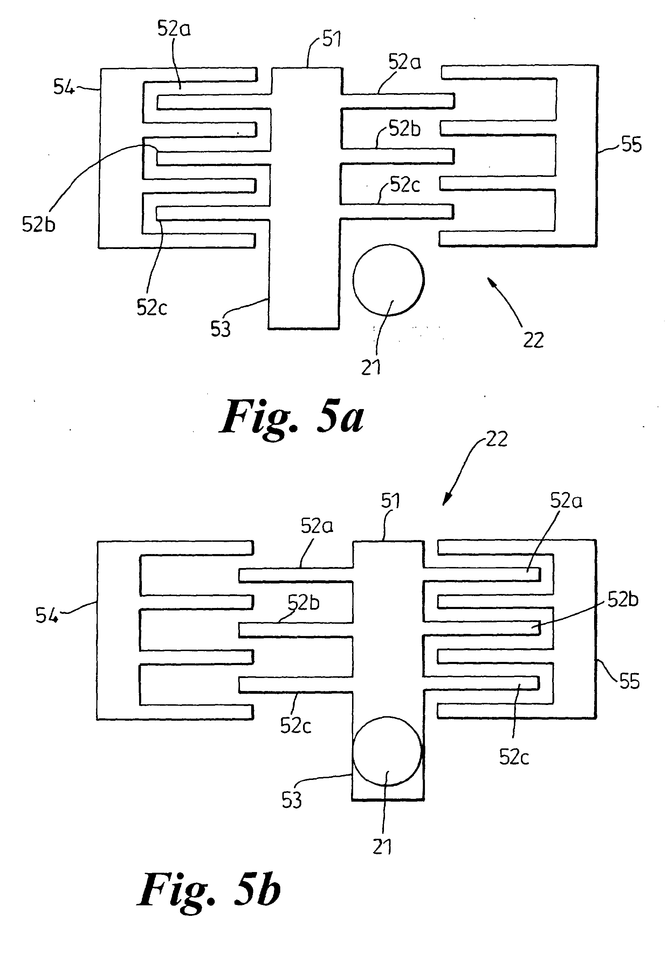

Figures 5a and 5b show a Micro-electro-mechanical system (MEMS) implementation of the VOA 22. A vane 53 forms one end of central movable member 51 which has comb teeth 52a, 52b, 52c disposed along two edges. The comb teeth are interdigitated with the teeth of two fixed combs 54, 55. By applying appropriate potentials controlled by a circuit mounted on a PCB 30 within the module housing, to the fixed combs 54, 55 and to the movable member 51, the vane 53 can be displaced sideways to occlude the collimated beam 21, shown in section as a circle. The movable member is suspended on flexures (not shown).

As will be appreciated, any mechanical actuator can be utilized for moving the vane. The art of micro-machining provides many such mechanisms and as such, the particular actuator mechanisms will not be discussed in detail here. Mechanisms that utilize sliding actuators are well known to those in the micro-machining arts. Alternatively, the vane can be positioned on "flip-up" or rotary actuators.

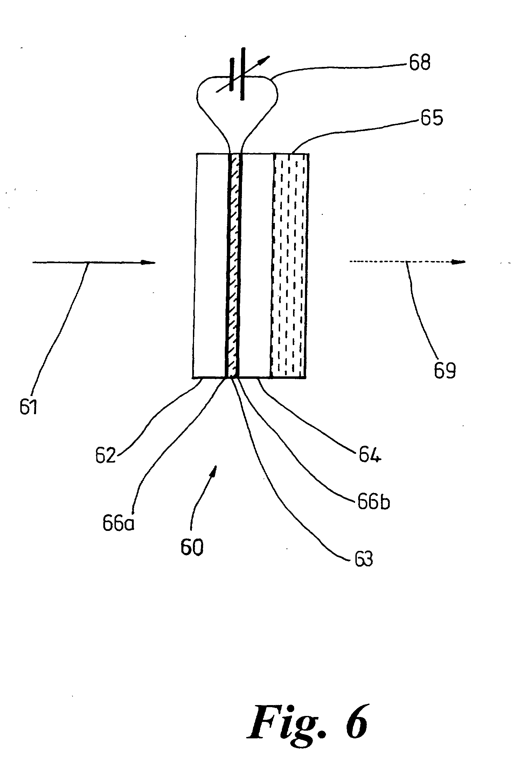

Figure 6 shows a liquid crystal (LC) implementation 60 of a VOA. An LC VOA can be used as an alternative to the mechanical VOA 22 described above in figures 5a and 5b. In figure 6 the collimated light beam 61 is incident from the left through a first glass plate 62, a thin layer of liquid crystal material 63, a second glass plate 64 and a polariser 65. The inner faces of the glass plates are covered with transparent, conductive material, such as indium tin oxide, to form electrodes 66a, 66b. As the light propagates through the liquid crystal its plane of polarisation rotates, and the angle of rotation depends on the potential between the electrodes. Thus the fraction of light transmitted by the polariser varies in response to the potential 68 between the electrodes, which is controlled by circuit mounted on PCB 30 within the module housing.

As will be appreciated by the skilled person, many other types of VOA are known including; moving fibres and shutters, devices based on electrooptic, thermooptic, photothermal, acoustooptic, magnetooptic, electrochromic and electrostrictive effects, and further uses of polarisation.

It is not intended that the present invention be limited to the above embodiments and other modifications and variations are envisaged within the scope of the claims. For example, any of the above mentioned other types of VOAs may be incorporated into the present invention.

## Claims

1. An optoelectronic module (20) comprising a light source (24), a variable optical attenuator (22), and an output means (28), wherein said light source and said output means are optically connected via said variable optical attenuator; **characterized in that** said light source, said variable optical attenuator and said output means are disposed within a housing (34).

2. A module as claimed in Claim 1, wherein said output means (28) is a fibre stub.

3. A module as claimed in any preceding claim, wherein said light source (24) is a laser.

4. A module as claimed in any preceding Claim, wherein said module further comprises an isolator (23) disposed within said housing (34).

5. A module as claimed in any preceding claim, wherein said module further comprises means for monitoring light transmitted by said variable optical attenuator.

6. A module as claimed in Claim 5, wherein said means for monitoring light comprises a beam splitter (40) and a detector (42).

7. A module as claimed in any preceding Claim, wherein said variable optical attenuator (22) is a micro-electromechanical variable optical attenuator.

8. A module as claimed in any of preceding Claims 1 -6, wherein said variable optical attenuator (22) is a liquid crystal variable optical attenuator.

9. A module as claimed in any preceding Claim, wherein said module is "hot pluggable".

10. A module as claimed in any preceding Claim wherein said module is an optical transceiver for use in a dense wavelength division multiplexing system.
